# EUROPEAN PATENT APPLICATION

(11) **EP 0 768 755 A1**
(43) Date of publication of application: **16.04.1997**
(21) Application number: 96307210.3
(22) Date of filing: 02.10.1996
(51) Int. Cl.: H03H 11/12, H03F 3/45

(54) **Active low-pass filter circuit**

(30) Priority: 10.10.1995 US 541714
(71) Applicant: SGS-THOMSON MICROELECTRONICS, INC., Carrollton Texas 75006-5039 (US)
(72) Inventor: Carobolante, Francesco, Scotts Valley, California 95066 (US)
(74) Representative: Palmer, Roger

(57) **Abstract**

A low-pass filter having a RC network coupled to a high bandwidth amplifier to provide a good transfer function and to a low offset voltage amplifier so that the output has a low DC offset voltage is disclosed. The RC network includes two resistors and two capacitors.

## Description

This invention relates to electronic circuits used to filter low frequencies and more specifically to active low-pass filters.

The problem addressed by this invention is encountered in the design of active low-pass filters using operational amplifiers (op amps). Low-pass filters are used in a multitude of applications including motor control circuits used in disk drives.

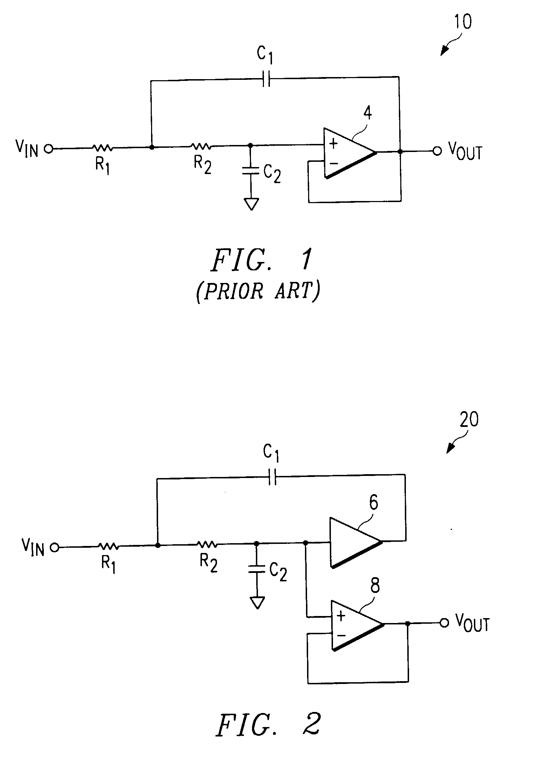

Figure 1 illustrates a typical active low-pass filter design as is known in the prior art. This circuit shows an op amp 4 configured with resistors R1, R2, C1, and C2 which is a second order filter with a frequencies response determined by selection of capacitor and resistor values, as is generally known by persons skilled in the art.

However, the equation assumes that op amp 4 performs as an ideal operation amplifier having large bandwidth and zero offset voltage. The high bandwidth is need in the forward path to obtain a good transfer function while a low offset voltage is needed in the forward path to avoid degrading the DC performance of the filter. Persons skilled in the art will appreciate that, in operational amplifiers, large bandwidths and zero offset voltages are often conflicting requirements. Thus, a designer is often faced with selecting a comparator with either large bandwidth or low offset voltage to meet a particular design criteria. As a third compromise, designers can design an op amp which maximizes the bandwidth while minimizes the offset voltage. However, the design often yields a design which may not have either the desired bandwidth nor the offset voltage since these requirements are conflicting.

Therefore, it is an object of the invention to provide a low-pass filter design which has a good transfer function and yet has a low DC offset voltage.

It is another object of the invention to provide a low-pass filter which benefits from an op amp with a broad bandwidth and an op amp with a low DC offset voltage.

The invention can be summarized as a low-pass filter having a RC network coupled to a high bandwidth amplifier to provide a good transfer function and to a low offset voltage amplifier so that the output has a low DC offset voltage. The RC network includes two resistors and two capacitors.

These and other objects, features, and advantages of the invention will be apparent to those skilled in the art from the following detailed description of the invention, when read with the drawings and appended claims.

Fig. 1 is a schematic drawing of a low-pass filter as known in the prior art.

Fig. 2 is a schematic drawing of a low-pass filter as disclosed by the inventor.

Referring now to Fig. 2, a low-pass filter constructed according to a the preferred embodiment of the invention will now be described. The low-pass filter is constructed by connecting an RC network to a high bandwidth amplifier and to a low offset voltage amplifier. More specifically, the RC network is made from resistor R1, resistor R2, capacitor C1, and capacitor C2. The first end of resistor R1 forms the input of the low-pass filter 20 and the second end is connected to the first end of resistor R2 and to the first plate of capacitor C1. The second end of resistor R2 is connected to the first plate of capacitor C2, the input of amplifier 6, and the noninverting input of amplifier 8. The output of amplifier 6 is connected to the second plate of capacitor C1. The output of amplifier 8 is fed back to its inverting input and also forms the output of low-pass filter 20. The desired cutoff frequency of low-pass filter is controlled by the capacitor and resistor selection just like the prior art circuit in Figure 1.

Amplifier 6 is selected to have a high bandwidth so that filter 20 obtains a good transfer function. It will be appreciated by persons skilled in the art that any open loop high speed buffer can be used even if it introduces a large offset voltage. Conversely, amplifier 8 is selected to have a low offset voltage so that low pass filter 20 obtains good DC performance. The bandwidth of amplifier needs only be as wide as the cutoff frequency of the filter.

The example in Fig. 2 shows amplifier 8 configured to have unity gain. Persons skilled in the art will appreciate that amplifier 8 can also be configured to provide any gain of either positive or negative polarity without departing from the spirit of the invention.

By using filter 20 with a high bandwidth amplifier and a low offset voltage amplifier, low-pass filter 20 provides a low-pass filter design which has a good transfer function and yet has a low DC offset voltage. Additionally, low-pass filter 20 provides a low-pass filter which benefits from an op amp with a broad bandwidth and an op amp with a low DC offset voltage, in essence, benefiting from otherwise conflicting criteria.

Although the invention has been described and illustrated with a certain degree of particularity, it is understood that the present disclosure has been made only by way of example, and that numerous changes in the combination and arrangement of parts can be resorted to by those skilled in the art without departing from the spirit and scope of the invention, as hereinafter claimed.

## Claims

1. A low-pass filter comprising:
a first amplifier;
an RC network coupled to the first amplifier; and
a second amplifier coupled to the first amplifier and the RC network.

2. The low-pass filter of claim 1 wherein the first amplifier comprises a high bandwidth amplifier.

3. The low-pass filter of claim 1 wherein the second amplifier comprises a low offset voltage amplifier.

4. The low-pass filter of claim 1 wherein the first amplifier comprises a high bandwidth amplifier and the second amplifier comprises a low offset voltage amplifier.

5. A low-pass filter comprising:
a first resistor and a second resistor coupled in series, having a first end for receiving a Vin voltage, having a common node, and having a second end,;
a first amplifier having an input and having an output;
a first capacitor coupled between the output of the first amplifier and the common node of the first and the second resistor;
a second capacitor having a first plate coupled to the input of the first amplifier and to the second end of the first and second resistor; and
a second amplifier having a input coupled to the input of the first amplifier and having an output which is the output of the low-pass filter.

6. The low-pass filter of claim 5 wherein the first amplifier is a high bandwidth amplifier.

7. The low-pass filter of claim 5 wherein the second amplifier is a low offset voltage amplifier.

8. The low-pass filter of claim 5 wherein the first amplifier comprises a high bandwidth amplifier and the second amplifier comprises a low offset voltage amplifier.

9. A method for filtering frequencies comprising the steps of
attenuating high frequencies; and
amplifying the attenuated frequencies.

10. The method of claim 9 wherein the step of attenuating high frequencies is performed by a high bandwidth amplifier.

11. The method of claim 10 wherein the step of amplifying the attenuated high frequencies is performed by a low offset voltage amplifier.

12. A disk drive which includes a low-pass filter, wherein the low-pass filter further comprises:
a first amplifier;
an RC network coupled to the first amplifier; and
a second amplifier coupled to the high bandwidth amplifier and the RC network.

13. The low-pass filter of claim 12 wherein the first amplifier comprises a high bandwidth amplifier.

14. The low-pass filter of claim 12 wherein the second amplifier comprises a low offset voltage amplifier.

15. The low-pass filter of claim 12 wherein the first amplifier comprises a high bandwidth amplifier and the second amplifier comprises a low offset voltage amplifier.
